# EUROPEAN PATENT APPLICATION

(11) **EP 4 790 742 A1**
(43) Date of publication of application: **12.08.2026**
(21) Application number: 23954742.5
(22) Date of filing: 04.10.2023
(51) Int. Cl.: H01L 21/3065

(54) **PROCESSING METHOD, METHOD FOR PRODUCING SEMICONDUCTOR DEVICE, PROGRAM, AND PROCESSING DEVICE**

(71) Applicant: Kokusai Electric Corporation, Tokyo 100-0004 (JP)
(72) Inventor: YAMAMOTO, Takayuki, Toyama-shi, Toyama 939-2393 (JP)
(74) Representative: Verscht, Thomas Kurt Albert
(86) International application number: PCT/JP2023/036162
(87) International publication number: WO 2025/074530

(57) **Abstract**

The present invention comprises a step of etching a film by carrying out a cycle a predetermined number of times, the cycle including (a) a step of supplying a reformed gas to the film, (b) a step of supplying an inert gas to the film, and (c) a step of supplying an etching gas to the film. At least a part of the duration of step (a) and the duration of step (b) overlaps.

## Description

### [Technical Field]

The present disclosure relates to a processing method, a method of manufacturing a semiconductor device, a program and a processing apparatus.

### [Related Art]

As a part of a manufacturing process of a semiconductor device, a process of etching a substrate may be performed (for example, see Patent Document 1).

### [Related Art Document]

### [Patent Document]

Patent Document 1: Japanese Patent Laid-Open No. 2022-136221

### [Disclosure]

### [Technical Problem]

According to the present disclosure, there is provided a technique capable of improving a controllability in etching a substrate.

### [Technical Solution]

According to an embodiment of the present disclosure, there is provided a technique that includes: etching a film by performing a cycle a predetermined number of times, wherein the cycle includes: (a) supplying a modifying gas to the film; (b) supplying an inert gas to the film; and (c) supplying an etching gas to the film, wherein an execution period of (a) and an execution period of (b) are at least partially overlapped with each other in the cycle.

### [Advantageous Effects]

According to some embodiments of the present disclosure, it is possible to improve a controllability in etching a substrate.

### [Brief Description of Drawings]

FIG. 1 is a diagram schematically illustrating a vertical cross-section of a process furnace 202 of a processing apparatus used in embodiments of the present disclosure.
FIG. 2 is a diagram schematically illustrating a horizontal cross-section, taken along a line A - A shown in FIG. 1, of the process furnace 202 of the processing apparatus used in the embodiments of the present disclosure.
FIG. 3 is a block diagram schematically illustrating a configuration of a controller 121 and its related components of the processing apparatus used in the embodiments of the present disclosure.
FIG. 4 is a diagram schematically illustrating a substrate process sequence according to the embodiments of the present disclosure.

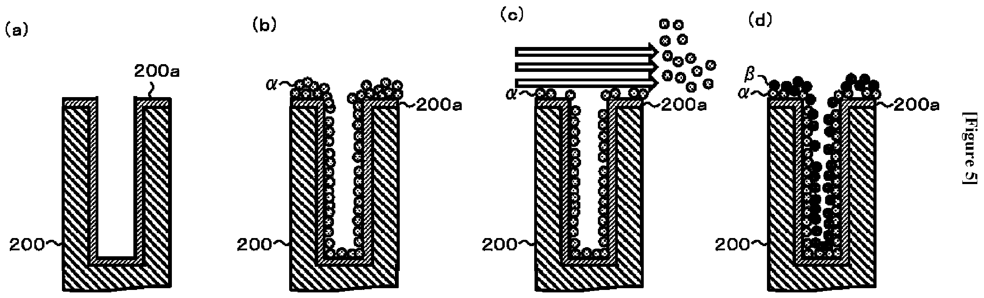

FIG. 5(a) is a diagram schematically illustrating an enlarged cross-section of a surface of a wafer 200 with a recess formed thereon, which is processed in a substrate processing according to the embodiments of the present disclosure, FIG. 5(b) is a diagram schematically illustrating an enlarged cross-section of the surface of the wafer 200 according to the embodiments of the present disclosure, after a modifying gas is supplied to a film 200a formed on a surface of the recess, FIG. 5(c) is a diagram schematically illustrating an enlarged cross-section of the surface of the wafer 200 according to the embodiments of the present disclosure, after an inert gas is supplied to the film 200a, and FIG. 5(d) is a diagram schematically illustrating an enlarged cross-section of the surface of the wafer 200 according to the embodiments of the present disclosure, after an etching gas is supplied to the film 200a.

### DETAILED DESCRIPTION

### <Embodiments of Present Disclosure>

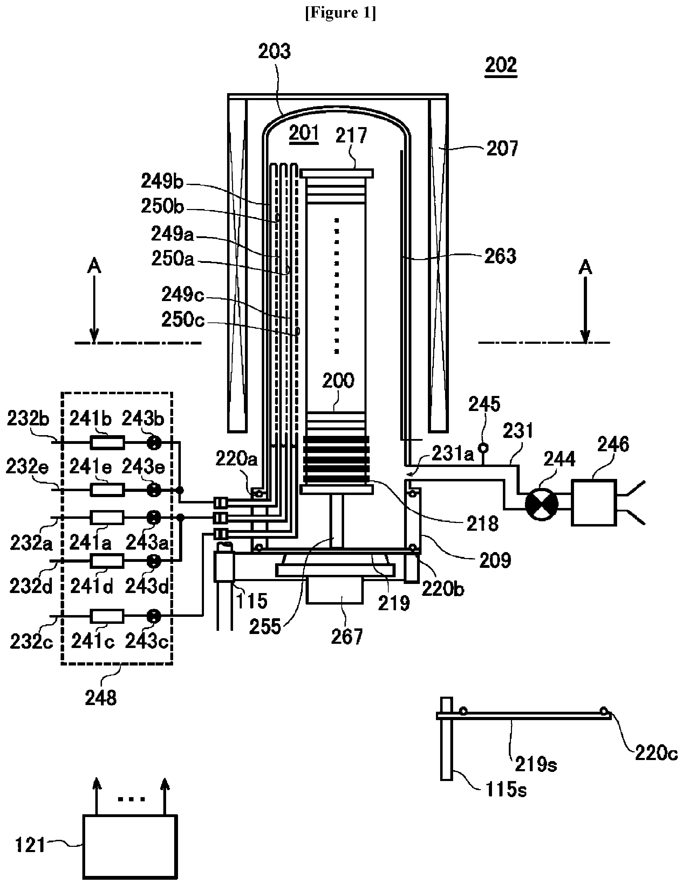

Hereinafter, embodiments according to the present disclosure will be described mainly with reference to FIGS. 1 to 4 and FIGS. 5(a) to FIG. 5(d). For example, the drawings used in the following description are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Processing Apparatus

As shown in FIG. 1, a process furnace 202 of a processing apparatus includes a heater 207 serving as a temperature regulator (which is a temperature adjusting structure or a heating structure). The heater 207 is of a cylindrical shape, and is vertically installed while being supported by a support plate. The heater 207 also functions as an activator (also referred to as an "exciter") capable of activating (or exciting) a gas by a heat.

A reaction tube 203 is provided in an inner side of the heater 207 to be aligned in a manner concentric with the heater 207. For example, the reaction tube 203 is made of a heat resistant material such as quartz (SiO₂) and silicon carbide (SiC). For example, the reaction tube 203 is of a cylindrical shape with a closed upper end and an open lower end. A manifold 209 is provided under the reaction tube 203 to be aligned in a manner concentric with the reaction tube 203. For example, the manifold 209 is made of a metal material such as stainless steel (SUS). For example, the manifold 209 is of a cylindrical shape with open upper and lower ends. An upper end portion of the manifold 209 is engaged with a lower end portion of the reaction tube 203 so as to support the reaction tube 203. An O-ring 220a serving as a seal is provided between the manifold 209 and the reaction tube 203. Similar to the heater 207, the reaction tube 203 is installed vertically. A process vessel (also referred to as a "reaction vessel") is constituted mainly by the reaction tube 203 and the manifold 209. A process chamber 201 is provided in a hollow cylindrical portion of the process vessel. The process chamber 201 is configured to be capable of accommodating a plurality of wafers 200 serving as substrates. The wafer 200 is processed in the process chamber 201.

Nozzles 249a, 249b and 249c are provided in the process chamber 201 so as to penetrate a side wall of the manifold 209. The nozzles 249a, 249b and 249c may serve as a first supply structure, a second supply structure and a third supply structure, respectively. The nozzles 249a, 249b and 249c may also be referred to as a first nozzle, a second nozzle and a third nozzle, respectively. For example, each of the nozzles 249a, 249b and 249c is made of a heat resistant material such as quartz and silicon carbide (SiC). Gas supply pipes 232a, 232b and 232c are connected to the nozzles 249a, 249b and 249c, respectively. The nozzles 249a, 249b and 249c are different nozzles, and the nozzles 249b and 249c are provided adjacent to the nozzle 249a.

Mass flow controllers (also simply referred to as "MFCs") 241a, 241b and 241c serving as flow rate controllers (flow rate control structures) and valves 243a, 243b and 243c serving as opening/closing valves are sequentially installed at the gas supply pipes 232a, 232b and 232c, respectively, in this order from upstream sides to downstream sides of the gas supply pipes 232a, 232b and 232c in a gas flow direction. A gas supply pipe 232d is connected to the gas supply pipe 232a at a downstream side of the valve 243a. A gas supply pipe 232e is connected to the gas supply pipe 232b at a downstream side of the valve 243b. MFCs 241d and 241e and valves 243d and 243e are sequentially installed at the gas supply pipes 232d and 232e, respectively, in this order from upstream sides to downstream sides of the gas supply pipes 232d and 232e in the gas flow direction. For example, each of the gas supply pipes 232a to 232e is made of a metal material such as SUS.

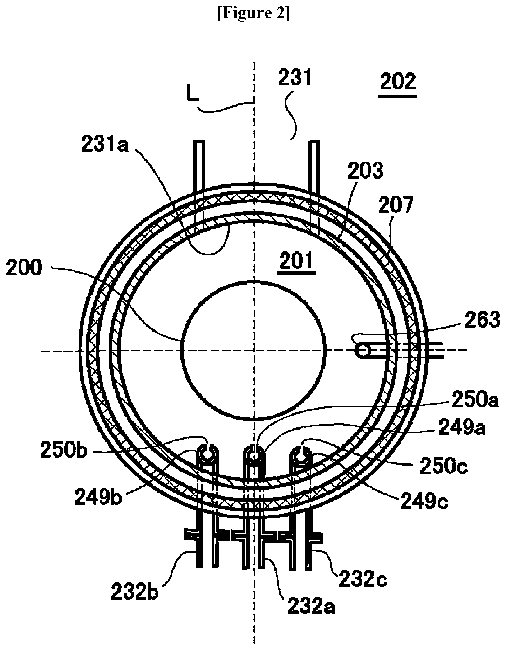

As shown in FIG. 2, each of the nozzles 249a to 249c is installed in an annular space provided between an inner wall of the reaction tube 203 and the wafers 200 when viewed from above, and extends upward from a lower portion toward an upper portion of the reaction tube 203 along the inner wall of the reaction tube 203 (that is, extends upward along an arrangement direction of the wafers 200). That is, each of the nozzles 249a to 249c is installed in a region that is located beside and horizontally surrounds a wafer arrangement region in which the wafers 200 are arranged (stacked) along the wafer arrangement region. When viewed from above, the nozzle 249a is arranged so as to face an exhaust port 231a described later along a straight line with a center of the wafer 200 in the process chamber 201 interposed therebetween. The nozzles 249b and 249c are arranged along the inner wall of the reaction tube 203 (that is, along an outer periphery of the wafer 200) such that the straight line L passing through the nozzle 249a and a center of the exhaust port 231a is interposed therebetween. The straight line L may also be referred to as a straight line passing through the nozzle 249a and the center of the wafer 200. That is, it can be said that the nozzle 249c is provided opposite to the nozzle 249b with the straight line L interposed therebetween. The nozzles 249b and 249c are arranged line-symmetrically (that is, in a line symmetry) with respect to the straight line L serving as an axis of symmetry. A plurality of gas supply holes 250a, a plurality of gas supply holes 250b and a plurality of gas supply holes 250c are provided at side surfaces of the nozzles 249a, 249b and 249c, respectively. Gases are supplied via the gas supply holes 250a, the gas supply holes 250b and the gas supply holes 250c, respectively. The gas supply holes 250a, the gas supply holes 250b and the gas supply holes 250c are open toward (that is, open to face) the exhaust port 231a when viewed from above, and are configured such that the gases are supplied toward the wafers 200 via the gas supply holes 250a, the gas supply holes 250b and the gas supply holes 250c. The gas supply holes 250a, the gas supply holes 250b and the gas supply holes 250c are provided from the lower portion toward the upper portion of the reaction tube 203.

A modifying gas is supplied into the process chamber 201 through the gas supply pipe 232a provided with the MFC 241a and the valve 243a and the nozzle 249a.

An etching gas is supplied into the process chamber 201 through the gas supply pipe 232b provided with the MFC 241b and the valve 243b and the nozzle 249b.

An inert gas is supplied into the process chamber 201 via the gas supply pipes 232c to 232e provided with the MFCs 241c to 241e and the valves 243c to 243e, respectively, the gas supply pipes 232a to 232c and the nozzles 249a to 249c. For example, the inert gas may act as a purge gas, a carrier gas, a dilution gas and the like.

A modifying gas supplier (which is a modifying gas supply system) is constituted mainly by the gas supply pipe 232a, the MFC 241a and the valve 243a. The modifying gas supplier may also be referred to as a "first gas supplier" which is a first gas supply system. An etching gas supplier (which is an etching gas supply system) is constituted mainly by the gas supply pipe 232b, the MFC 241b and the valve 243b. The etching gas supplier may also be referred to as a "third gas supplier" which is a third gas supply system. An inert gas supplier (which is an inert gas supply system) is constituted mainly by the gas supply pipes 232c to 232e, the MFCs 241c to 241e and the valves 243c to 243e. The inert gas supplier may also be referred to as a "second gas supplier" which is a second gas supply system.

Any one or an entirety of the gas suppliers described above may be configured as an integrated gas supply system 248 in which components such as the valves 243a to 243e and the MFCs 241a to 241e are integrated. The integrated gas supply system 248 is connected to each of the gas supply pipes 232a to 232e. Operations of the integrated gas supply system 248 to supply various gases to the gas supply pipes 232a to 232e, for example, operations such as an operation of opening and closing the valves 243a to 243e and operations of adjusting flow rates of the gases by the MFCs 241a to 241e may be controlled by a controller 121 described later. The integrated gas supply system 248 may be embodied as an integrated structure (integrated unit) of an all-in-one type or a divided type. The integrated gas supply system 248 can be attached to or detached from the components such as the gas supply pipes 232a to 232e on a basis of the integrated structure. Operations such as maintenance, replacement and addition for the integrated gas supply system 248 can be performed on a basis of the integrated structure.

The exhaust port 231a through which an inner atmosphere of the process chamber 201 is exhausted is provided at a lower side wall of the reaction tube 203. As shown in FIG. 2, the exhaust port 231a is arranged at a location so as to face (or opposite to) the nozzles 249a to 249c (the gas supply holes 250a to the gas supply holes 250c) with the wafer 200 interposed therebetween when viewed from above. The exhaust port 231a may be provided so as to extend upward from the lower portion toward the upper portion of the reaction tube 203 along a side wall of the reaction tube 203 (that is, along the wafer arrangement region). An exhaust pipe 231 is connected to the exhaust port 231a. A vacuum pump 246 serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect an inner pressure of the process chamber 201, and the APC valve 244 serves as a pressure regulator (pressure adjusting structure). With the vacuum pump 246 in operation, the APC valve 244 may be opened or closed to perform a vacuum exhaust operation for the process chamber 201 or stop the vacuum exhaust operation. In addition, with the vacuum pump 246 in operation, the inner pressure of the process chamber 201 may be adjusted by adjusting an opening degree of the APC valve 244 based on pressure information detected by the pressure sensor 245. An exhauster (which is an exhaust system) is constituted mainly by the exhaust pipe 231, the APC valve 244 and the pressure sensor 245. The exhauster may further include the vacuum pump 246.

A seal cap 219 (hereinafter, also referred to as a "cap 219") serving as a furnace opening lid capable of airtightly sealing (closing) a lower end opening of the manifold 209 is provided under the manifold 209. For example, the cap 219 is made of a metal material such as SUS, and is of a disk shape. An O-ring 220b serving as a seal is provided on an upper surface of the cap 219 so as to be in contact with the lower end of the manifold 209. A rotator (which is a rotating structure) 267 configured to rotate a boat 217 described later is provided under the cap 219. For example, a rotating shaft 255 of the rotator 267 is connected to the boat 217 through the cap 219. The rotator 267 is configured to rotate the wafers 200 by rotating the boat 217. The cap 219 is configured to be elevated or lowered in a vertical direction by a boat elevator 115 (hereinafter, also referred to as an "elevator 115") serving as an elevating structure provided outside the reaction tube 203. The elevator 115 serves as a transfer apparatus (which is a transfer structure) capable of transferring (loading) the wafers 200 into the process chamber 201 and capable of transferring (unloading) the wafers 200 out of the process chamber 201 by elevating and lowering the cap 219.

A shutter 219s serving as a furnace opening lid capable of airtightly sealing (closing) the lower end opening of the manifold 209 is provided under the manifold 209. The shutter 219s is configured to close the lower end opening of the manifold 209 when the cap 219 is lowered by the elevator 115 and the boat 217 is unloaded out of the process chamber 201. For example, the shutter 219s is made of a metal material such as SUS, and is of a disk shape. An O-ring 220c serving as a seal is provided on an upper surface of the shutter 219s so as to be in contact with the lower end of the manifold 209. An opening and closing operation of the shutter 219s such as an elevation operation and a rotation operation is controlled by a shutter opener/closer (which is a shutter opening/closing structure) 115s.

The boat 217 serving as a substrate support is configured such that the wafers 200 (for example, 25 wafers to 200 wafers) are supported (or stacked) in the vertical direction in the boat 217 while the wafers 200 are horizontally oriented with their centers aligned with one another in a multistage manner. That is, the boat 217 is configured such that the wafers 200 are arranged in the vertical direction in the boat 217 while the wafers 200 are stacked in the vertical direction with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner.

A temperature sensor 263 serving as a temperature detector is installed in the reaction tube 203. A state of electric conduction to the heater 207 is adjusted based on temperature information detected by the temperature sensor 263 such that a desired temperature distribution of an inner temperature of the process chamber 201 can be obtained. The temperature sensor 263 is provided along the inner wall of the reaction tube 203.

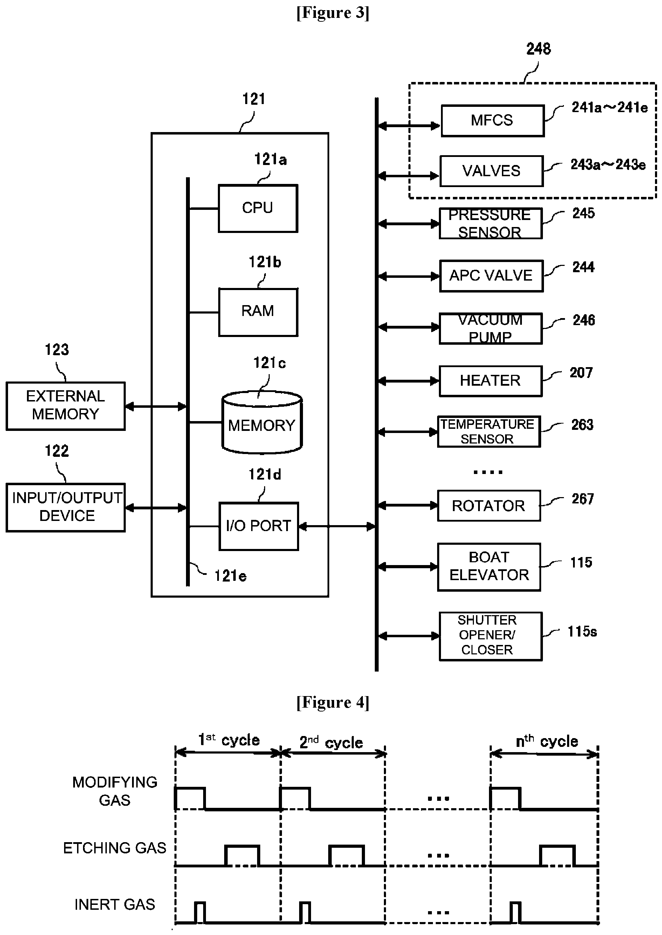

As shown in FIG. 3, the controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the controller 121. In addition, the controller 121 is configured to be capable of being connected to an external memory 123. For example, as the control structure, the processing apparatus may include a single control structure, or include a plurality of control structures. That is, a control operation of performing a process sequence described later may be performed using the single control structure, or may be performed using the plurality of control structures. In addition, the plurality of control structures may be configured as a control system that are connected to one another via a wired or wireless communication network, and an entirety of the control system may perform the control operation of performing the process sequence described later. Thus, in the present specification, the term "control structure" may refer to the single control structure, may refer to the plurality of control structures, or may refer to the control system configured by the plurality of control structures.

For example, the memory 121c is configured by a component such as a flash memory, a hard disk drive (HDD) and a solid state drive (SSD). For example, a control program configured to control an operation of the processing apparatus and a process recipe containing information on procedures and conditions of a substrate processing described later may be readably stored in the memory 121c. The process recipe is obtained by combining steps (procedures) of the substrate processing described later such that the controller 121 can execute the steps by the processing apparatus to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area where a program or data read by the CPU 121a is temporarily stored.

The I/O port 121d is connected to the components described above such as the MFCs 241a to 241e, the valves 243a to 243e, the pressure sensor 245, the APC valve 244, the vacuum pump 246, the temperature sensor 263, the heater 207, the rotator 267, the elevator 115 and the shutter opener/closer 115s.

The CPU 121a is configured to read the control program from the memory 121c and execute the control program read from the memory 121c. In addition, the CPU 121a is configured to read the recipe from the memory 121c, for example, in accordance with an operation command inputted from the input/output device 122. In accordance with contents of the recipe read from the memory 121c, the CPU 121a may be configured to be capable of controlling various operations such as flow rate adjusting operations for various substances (various gases) by the MFCs 241a to 241e, opening and closing operations of the valves 243a to 243e, an opening and closing operation of the APC valve 244, a pressure adjusting operation by the APC valve 244 based on the pressure sensor 245, a start and stop operation of the vacuum pump 246, a temperature adjusting operation by the heater 207 based on the temperature sensor 263, an operation of adjusting a rotation and a rotation speed of the boat 217 by the rotator 267, an elevating and lowering operation of the boat 217 by the elevator 115 and an opening and closing operation of the shutter 219s by the shutter opener/closer 115s.

The controller 121 may be embodied by installing the above-described program stored in the external memory 123 into the computer. For example, the external memory 123 may include a magnetic disk such as the HDD, an optical disk such as a CD, and a semiconductor memory such as a USB memory and the SSD. The memory 121c or the external memory 123 may be embodied by a non-transitory computer readable recording medium storing the program. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program to the computer.

### (2) Substrate Processing

Hereinafter, an example of a process sequence of etching the wafer 200 serving as the substrate by using the processing apparatus (that is, a substrate processing apparatus) described above, which is a part of a manufacturing process of a semiconductor device, will be described mainly with reference to FIGS. 4 and FIGS. 5(a) to 5(d). In the following description, operations of components constituting the processing apparatus are controlled by the controller 121.

As the wafer 200 to be processed in the substrate processing in the embodiments of the present disclosure, for example, a silicon (Si) substrate made of single crystal silicon (Si) may be used. As shown in FIG. 5(a), on a surface of the wafer 200, a recess (concave structure) such as a trench and a hole is provided (formed) with a natural oxide film 200a such as a silicon oxide film (SiO film) formed thereon. Hereinafter, the natural oxide film 200a may also be simply referred to as a "film 200a".

As shown in FIG. 4, the process sequence of the present embodiments may include a step of etching the film 200a by performing a cycle a predetermined number of times (n times, n is an integer of 1 or 2 or more), wherein the cycle may include: (a) a step A of supplying the modifying gas to the film 200a; (b) a step B of supplying the inert gas to the film 200a; and (c) a step C of supplying the etching gas to the film 200a. In the cycle, an execution period (time duration) of the step A and an execution period (time duration) of the step B are at least partially overlapped with each other.

In addition, as shown in FIG. 4, in the process sequence of the present embodiments, the step A may be started before the step B, and the step B is started while the step A is still being performed. In the present embodiments, a case where the step B is performed in the later stage (latter half) of the execution period of the step A will be described.

In addition, in the present embodiments, for example, a case where a step (hereinafter, also referred to as a "step D") of increasing the inner temperature of the process chamber 201 is performed after the step C is performed will be described.

In the present specification, for convenience of explanation, the process sequence mentioned above may be illustrated as follows. Similar notations will be used in explanations of modified examples and other embodiments described later.

### (Modifying gas + Inert gas → Etching gas → Temperature Increase) × n

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "etching a predetermined layer (or a film) on a wafer" may refer to "etching a predetermined layer (or a film) directly on a surface of a wafer itself", or may refer to "etching a predetermined layer (or a film) formed on another layer (or another film) formed on a wafer". In the present specification, the terms "substrate" and "wafer" may be used as substantially the same meaning.

In the present specification, the term "substance" may contain at least one selected from the group of a gaseous substance and a liquid substance. The liquid substance may contain a mist substance. That is, the substance may contain a gaseous substance, may contain a liquid substance such as a mist substance, or may contain both of the gaseous substance and the liquid substance.

### <Charging and Boat Loading>

When the plurality of wafers 200 are charged (loaded or transferred) into the boat 217, the shutter 219s is moved by the shutter opener/closer 115s to open the lower end opening of the manifold 209. Then, as shown in FIG. 1, the boat 217 supporting the plurality of wafers 200 is elevated by the elevator 115 and loaded (transferred) into the process chamber 201 (boat loading). In such a state, the cap 219 airtightly seals the lower end opening of the manifold 209 via the O-ring 220b. In such a manner, the wafers 200 are prepared (provided) in the process chamber 201.

### <Pressure Adjusting and Temperature Adjusting>

After the boat loading is completed, the vacuum pump 246 vacuum-exhausts (decompresses and exhausts) an inside (inner portion) of the process chamber 201 (that is, a space in which the wafers 200 are present (accommodated)) such that the inner pressure of the process chamber 201 reaches and is maintained at a desired pressure (vacuum degree). At this time, the inner pressure of the process chamber 201 is measured by the pressure sensor 245, and the APC valve 244 is feedback-controlled based on the pressure information detected by the pressure sensor 245. In addition, the heater 207 heats the process chamber 201 such that a temperature of the wafer 200 in the process chamber 201 reaches and is maintained at a desired process temperature. At this time, the state of the electric conduction to the heater 207 is feedback-controlled based on the temperature information detected by the temperature sensor 263 such that a desired temperature distribution of the inner temperature of the process chamber 201 can be obtained. In addition, a rotation of the wafer 200 is started by the rotator 267. The vacuum pump 246 continuously vacuum-exhausts the inner atmosphere of the process chamber 201, the heater 207 continuously heats the wafer 200 in the process chamber 201 and the rotator 267 continuously rotates the wafer 200 until at least a processing of the wafer 200 is completed.

### <Etching>

Then, the following steps A to D are sequentially performed in this order.

### <Step A>

In the present step, the modifying gas is supplied to the wafer 200 in the process chamber 201, that is, to the film 200a formed on the surface of the wafer 200.

Specifically, the valve 243a is opened to supply the modifying gas into the gas supply pipe 232a. A flow rate of the modifying gas is adjusted by the MFC 241a, and the modifying gas whose flow rate is adjusted is supplied into the process chamber 201 through the nozzle 249a and exhausted through the exhaust port 231a. At this time, the modifying gas is supplied to the wafer 200 from a direction different from a bottom direction of the recess on the surface of the wafer 200 (modifying gas supply). In the present specification, the bottom direction of the recess may refer to a direction perpendicular to an upper surface of the recess. In addition, for example, the direction different from the bottom direction of the recess may refer to a direction substantially perpendicular to the bottom direction of the recess. In addition, when the recess is formed by extending in a thickness direction of the wafer 200, the direction different from the bottom direction of the recess is a direction substantially parallel to the surface of the wafer 200. In addition, when the recess is formed by extending in the direction substantially parallel to the surface of the wafer 200, the direction different from the bottom direction of the recess is a direction perpendicular to the surface of the wafer 200.

For example, process conditions when supplying the modifying gas in the present step are as follows:
A process temperature: from 20 °C to 75 °C, preferably from 25 °C to 70°C;
A process pressure: from 1 Pa to 10,000 Pa, preferably from 10 Pa to 1,333 Pa;
A supply flow rate of the modifying gas: from 0.01 slm to 3 slm, preferably from 0.1 slm to 1 slm; and
A supply time (time duration) of supplying the modifying gas: from 30 seconds to 1,800 seconds, preferably from 50 seconds to 1,200 seconds.

It is preferable that the process pressure in the present step is set to be higher than a process pressure in the step C described later. In addition, in the present step, it is preferable that the inner pressure of the process chamber 201 is set to the process pressure mentioned above with the modifying gas being supplied in an un-decomposed state.

In the present specification, a notation of a numerical range such as "from 20 °C to 75 °C" means that a lower limit and an upper limit are included in the numerical range. Therefore, for example, the numerical range "from 20 °C to 75 °C" means a range equal to or higher than 20 °C and equal to or less than 75 °C. The same also applies to other numerical ranges described in the present specification. In addition, in the present specification, the term "process temperature" may refer to the "temperature of the wafer 200" or the "inner temperature of the process chamber 201", and the term "process pressure" may refer to the inner pressure of the process chamber 201, that is, a pressure of the space in which the wafers 200 are present. In addition, the term "process time" may refer to a time duration of continuously performing a process related thereto. In addition, when a supply flow rate of a substance (gas) includes "0 slm", it refers to a case where the substance (gas) is not supplied. The same also applies to the following description.

By supplying the modifying gas to the wafer 200 (that is, the film 200a) under the process conditions mentioned above, on a surface of the film 200a, it is possible to adsorb at least one among the following: the modifying gas, a substance containing a part of a molecular structure of the modifying gas; and a specific element contained in the modifying gas (see FIG. 5(b)). Hereinafter, at least one among the modifying gas, the substance containing a part of the molecular structure of the modifying gas and the specific element contained in the modifying gas may also be referred to as "modifying gas and the like". In FIG. 5(b) to FIG. 5(d), the modifying gas and the like are indicated by the letter "α".

By supplying the modifying gas to the wafer 200 (that is, the film 200a) under the process conditions mentioned above, the modifying gas fills the recess formed in the wafer 200 from the upper surface on an opening side of the recess (hereinafter, also referred to as the upper surface of the recess) to a bottom surface inside the recess (hereinafter, also referred to as the bottom surface of the recess), and the modifying gas and the like are adsorbed to the upper surface of the recess, or side surfaces and the bottom surface of the recess (hereinafter, also referred to as the side and bottom surfaces of the recess). At this time, the modifying gas and the like are preferentially adsorbed to the upper surface of the recess rather than the side and bottom surfaces of the recess. In other words, an amount of the modifying gas and the like adsorbed to the upper surface of the recess is greater than that of the modifying gas and the like adsorbed to the side and bottom surfaces of the recess (see FIG. 5(b)).

As the modifying gas, for example, an NH group-containing gas such as ammonia (NH₃) gas, hydrazine (N₂H₄) gas, pyridine (C₅H₅N) gas, pyrimidine (C₄H₄N₂) gas and picoline (C₆H₇N) gas may be used. As the modifying gas, for example, one or more of the gases exemplified above may be used.

### <Step B>

When a predetermined time has elapsed from a start of the step A, the inert gas is supplied to the wafer 200 in the process chamber 201, that is, the film 200a to which the modifying gas and the like are adsorbed, while continuously performing the step A (see FIG. 4).

Specifically, in the later stage of the execution period of the step A, when the modifying gas and the like are adsorbed on the upper surface of the recess or the side and bottom surfaces of the recess, that is, the entire surface of the recess, while continuously supplying the modifying gas, the valves 243c to 243e are opened to supply the inert gas into the gas supply pipes 232c to 232e. A flow rate of the inert gas is adjusted by each of the MFCs 241c to 241e, and the inert gas whose flow rate is adjusted is supplied into the process chamber 201 through the nozzles 249a to 249c and exhausted through the exhaust port 231a. At this time, the inert gas is supplied to the wafer 200 from the direction different from the bottom direction of the recess (inert gas supply).

For example, process conditions when supplying the inert gas in the present step are as follows:
A process temperature: from 20 °C to 75 °C, preferably from 25 °C to 70°C;
A process pressure: from 1 Pa to 10,000 Pa, preferably from 10 Pa to 1,333 Pa;
A supply flow rate of the inert gas: from 0.01 slm to 3 slm, preferably from 0.1 slm to 1 slm; and
A supply time (time duration) of supplying the inert gas: from 10 seconds to 300 seconds, preferably from 20 seconds to 60 seconds.

It is preferable that the execution time (that is, the supply time of the inert gas) of the present step is set to be shorter than an execution time of the step A (that is, the supply time of the modifying gas). In addition, it is preferable that a supply amount of the inert gas in the present step is set to be smaller than a supply amount of the modifying gas in the step A. In addition, it is possible to calculate a supply amount of the gas by multiplying a supply flow rate of the gas by a supply time of the gas.

Under the process conditions mentioned above, by supplying the inert gas to the film 200a to which the modifying gas and the like are adsorbed, for example, from the direction different from the bottom direction of the recess, it is possible to peel off and remove (or desorb) a part of the modifying gas and the like adsorbed (laminated) on the upper surface of the recess (see FIG. 5(c)). On the other hand, even when the inert gas is supplied under the process conditions mentioned above, the modifying gas and the like adsorbed on the side and bottom surfaces of the recess are hardly peeled off. In such a way, according to the present embodiments, by adjusting the amount of the modifying gas and the like adsorbed on the surface of the recess, it is possible to set the amount of the modifying gas and the like adsorbed on the upper surface of the recess to be smaller than the amount of the modifying gas and the like adsorbed on the side and bottom surfaces of the recess (see FIG. 5(c)). In FIG. 5(c), a flow of the inert gas is indicated by arrows.

As the inert gas, for example, nitrogen (N₂) gas or a rare gas such as argon (Ar) gas, helium (He) gas, neon (Ne) gas and xenon (Xe) gas may be used. As the inert gas, for example, one or more of the gases exemplified above may be used. The same also applies to each step described below.

Thereafter, the valves 243a and 243c to 243e are closed to stop a supply of the modifying gas and a supply of the inert gas into the process chamber 201. Then, the process chamber 201 is vacuum-exhausted to remove a substance (such as a gaseous substance remaining in the process chamber 201) out of the process chamber 201. At this time, with the valves 243c to 243e being open, the inert gas may be supplied into the process chamber 201 through the nozzles 249a to 249c. The inert gas supplied through the nozzles 249a to 249c acts as the purge gas. Thereby, the space in which the wafers 200 are present (that is, the inside of the process chamber 201) is purged.

### <Step C>

After the steps A and B are completed, the etching gas is supplied to the wafer 200 in the process chamber 201, that is, to the film 200a to which the modifying gas and the like are adsorbed (see FIG. 4).

Specifically, the valve 243b is opened to supply the etching gas into the gas supply pipe 232b. A flow rate of the etching gas is adjusted by the MFC 241b, and the etching gas whose flow rate is adjusted is supplied into the process chamber 201 through the nozzle 249b and exhausted through the exhaust port 231a. At this time, the etching gas is supplied to the wafer 200 (etching gas supply). At this time, the valves 243c to 243e may be opened to supply the inert gas into the process chamber 201 through each of the nozzles 249a to 249c.

For example, process conditions when supplying the etching gas in the present step are as follows:
A process temperature: from 20 °C to 75 °C, preferably from 25 °C to 70°C;
A process pressure: from 1 Pa to 10,000 Pa, preferably from 10 Pa to 1,333 Pa;
A supply flow rate of the etching gas: from 0.01 slm to 3 slm, preferably from 0.1 slm to 1 slm;
A supply time (time duration) of supplying the etching gas: from 10 seconds to 120 seconds, preferably from 20 seconds to 60 seconds; and
A supply flow rate of the inert gas (for each gas supply pipe): from 0 slm to 10 slm.

By supplying the etching gas to the wafer 200 (that is, the film 200a) under the process conditions mentioned above, to the modifying gas and the like adsorbed on the surface of the film 200a, it is possible to adsorb at least one among the following: the etching gas, a substance containing a part of a molecular structure of the etching gas; and a specific element contained in the etching gas (see FIG. 5(d)). Hereinafter, at least one among the etching gas, the substance containing a part of the molecular structure of the etching gas and the specific element contained in the etching gas may also be referred to as "etching gas and the like". In FIG. 5(d), the etching gas and the like are indicated by the letter "β".

By supplying the etching gas to the film 200a under the process conditions mentioned above, it is possible for the etching gas to reach from the upper surface of the recess formed in the wafer 200 to the bottom surface of the recess, and it is also possible to adsorb the etching gas and the like to the upper surface of the recess, or the side and bottom surfaces of the recess. At this time, the etching gas and the like are preferentially adsorbed to the upper surface of the recess rather than the side and bottom surfaces of the recess. In other words, an amount of the etching gas and the like adsorbed to the upper surface of the recess is greater than that of the etching gas and the like adsorbed to the side and bottom surfaces of the recess (see FIG. 5(d)).

As the etching gas, for example, a fluorine (F)-containing gas such as hydrogen fluoride (HF) gas, chlorine trifluoride (ClF₃) gas, fluorine (F₂) gas, nitrogen trifluoride (NF₃) gas and carbon tetrafluoride (CF₄) gas may be used. As the etching gas, for example, one or more of the gases exemplified above may be used.

After the etching gas and the like are adsorbed to the modifying gas and the like adsorbed on the surface of the film 200a, the valve 243b is closed to stop a supply of the etching gas into the process chamber 201. Then, the process chamber 201 is vacuum-exhausted to remove a substance (such as a gaseous substance remaining in the process chamber 201) out of the process chamber 201. At this time, with the valves 243c to 243e left open, the inert gas may be supplied into the process chamber 201 through the nozzles 249a to 249c. The inert gas supplied through the nozzles 249a to 249c acts as the purge gas. Thereby, the space in which the wafers 200 are present (that is, the inside of the process chamber 201) is purged.

### <Step D>

An output of the heater 207 is adjusted such that the inner temperature of the process chamber 201 (that is, the temperature of the wafer 200) is increased to a predetermined temperature. In addition, the inside of the process chamber 201 (that is, the space in which the wafers 200 are present) is vacuum-exhausted by the vacuum pump 246 such that the inner pressure of the process chamber 201 reaches and is maintained at a predetermined pressure. It is preferable that the present step is performed in an inert gas atmosphere. That is, when performing the present step, it is preferable to open the valves 243c to 243e and supply the inert gas into the process chamber 201 through the nozzles 249a to 249c to purge the inside of the process chamber 201.

For example, process conditions of the present step are as follows:
A process temperature: from 100 °C to 200 °C, preferably from 150 °C to 200°C;
A process pressure: from 1 Pa to 10,000 Pa, preferably from 10 Pa to 1,333 Pa;
A process time: from 0.5 hour to 5 hours; and
A supply flow rate of the inert gas (for each gas supply pipe): from 0 slm to 10 slm.

By performing a heat increasing process (heat treatment process) for the wafer 200 under the process conditions mentioned above, it is possible to etch the film 200a. Hereinafter, the present embodiments will be described by way of an example in which the film 200a formed on the surface of the recess is the SiO film, the NH₃ gas is used as the modifying gas and the HF gas is used as the etching gas. When the steps A and C are performed under the process conditions mentioned above such that the NH₃ gas (modifying gas) and the HF gas (etching gas) are supplied to the SiO film (film 200a), the NH₃ gas and the HF gas are adsorbed on the surface of the wafer 200 and react with the SiO film. The SiO film reacting with the NH₃ gas and the HF gas is modified into an ammonium hexafluorosilicate ((NH₄)SiF₆) film. Then, the step D is performed under the process conditions mentioned above such that the heat increasing process for the wafer 200 is performed. Thereby, the (NH₄)SiF₆ film is sublimated and removed (etched).

After etching the film 200a, the process chamber 201 is vacuum-exhausted to remove a substance (such as a gaseous substance remaining in the process chamber 201) out of the process chamber 201. At this time, the valves 243c to 243e are opened to supply the inert gas into the process chamber 201 through the nozzles 249a to 249c. The inert gas supplied through the nozzles 249a to 249c acts as the purge gas. Thereby, the space in which the wafers 200 are present (that is, the inside of the process chamber 201) is purged. At this time, the inner temperature of the process chamber 201 is lowered to the process temperature in the step A, when desired.

### <Performing Cycle Predetermined Number of Times>

By performing the cycle wherein the step A to the step D described above are sequentially performed in this order a predetermined number of times (n times, wherein n is an integer of 1 or 2 or more), it is possible to etch the film 200a formed on the surface of the wafer 200 to a desired depth. It is preferable that the cycle described above is repeatedly performed a plurality number of times. That is, it is preferable that the cycle is repeatedly performed the plurality number of times until a thickness of the film to be removed by the etching (etching process) reaches a desired thickness while a thickness of the film etched in each cycle is thinner than the desired thickness.

### <Purge and Returning to Atmospheric Pressure>

After the etching process is completed, the inert gas serving as the purge gas is supplied into the process chamber 201 through each of the nozzles 249a to 249c, and then is exhausted through the exhaust port 231a. Thereby, the process chamber 201 is purged with the inert gas. As a result, a substance such as a gas remaining in the process chamber 201 and reaction by-products remaining in the process chamber 201 is removed from the process chamber 201. Thereafter, the inner atmosphere of the process chamber 201 is replaced with the inert gas, and the inner pressure of the process chamber 201 is returned to the normal pressure (atmospheric pressure).

### <Unloading and Wafer Charging>

Thereafter, the cap 219 is lowered by the elevator 115 and the lower end of the manifold 209 is opened. Then, the boat 217 with the wafers 200 (which are processed and supported in the boat 217) is unloaded (transferred) out of the reaction tube 203 through the lower end of the manifold 209. After the boat 217 is unloaded, the shutter 219s is moved such that the lower end opening of the manifold 209 is sealed by the shutter 219s through the O-ring 220c. Then, the wafers 200 (which are processed) are discharged (transferred or unloaded) from the boat 217 unloaded out of the reaction tube 203.

### (3) Effects According to Present Embodiments

According to the present embodiments, it is possible to obtain one or more of the following effects.
(a) By overlapping the execution period of the step A and the execution period of the step B at least partially, it is possible to adjust the amount of the modifying gas and the like adsorbed on the surface of the film 200a. As a result, it is possible to adjust (or control) an etching amount of the film 200a. In particular, when the recess is formed on the surface of the wafer 200, it is possible to set an amount of the modifying gas present on the upper surface of the recess to be different from the amount of the modifying gas present on the side and bottom surfaces of the recess. In other words, it is possible to set an amount of the modifying gas present on the opening side of the recess to be different from an amount of the modifying gas present on a bottom side of the recess. As a result, it is possible to adjust (or control) the etching amounts of the film 200a formed on the upper surface of the recess and the film 200a formed on the side and bottom surfaces of the recess. Such a control will be described below. In addition, the amount of the modifying gas present as mentioned above is an amount of molecules of a material constituting the modifying gas itself and an amount of a part of the molecules. Further, the modifying gas includes a portion floating in a space inside the recess and a portion adsorbed on each surface inside the recess.

For example, when the gas is supplied to the wafer 200 with the recess formed on the surface thereof, the gas supplied to the wafer 200 tends to preferentially adsorb to the upper surface of the recess. In other words, the amount of the modifying gas (or the etching gas) adsorbed to the upper surface of the recess is greater than the amount of the modifying gas (or the etching gas) adsorbed to the side and bottom surfaces of the recess. Therefore, when etching the film 200a formed on the surface of the recess, the upper surface of the recess is etched more than the side and bottom surfaces of the recess. As a result, it may be difficult to etch the film 200a uniformly.

According to the present embodiments, the execution period of the step A and the execution period of the step B are partially overlapped with each other. Specifically, while the modifying gas is being supplied to the film 200a in the step A, the inert gas is supplied to the film 200a in the step B. As a result, it is possible to remove (desorb) a part of the modifying gas and the like adsorbed to the upper surface of the recess by supplying the inert gas (see FIG. 5(c)). In such a manner, it is possible to reduce the amount of the modifying gas and the like adsorbed (or present) on the upper surface of the recess. Thereafter, when the etching gas is supplied to the film 200a in the step C, the etching gas is preferentially adsorbed to the upper surface of the recess, but the amount of the modifying gas and the like adsorbed to the upper surface of the recess is small, so the etching amount of the film 200a on the upper surface of the recess is suppressed. On the other hand, the modifying gas and the like adsorbed (present) on the side and bottom surfaces of the recess are hardly affected by the inert gas supplied in the step B. Therefore, the amount of the modifying gas and the like present on the side and bottom surfaces of the recess is hardly reduced. Therefore, in the step C, the film 200a formed on the side and bottom surfaces of the recess is etched while hardly affected by the inert gas supplied in the step B. In such a manner, it is possible to adjust (control) the etching amount of the film 200a on the upper surface of the recess and on the side and bottom surfaces of the recess. As a result, it is possible to etch the film 200a uniformly.

(b) By setting the inner pressure of the process chamber 201 in the step A to be higher than the inner pressure of the process chamber 201 in the step C, that is, by performing the step A under a relatively high pressure, it is possible to fill an inside (inner portion) of the recess with the modifying gas, and it is possible to adsorb the modifying gas uniformly from the opening side to the bottom surface of the recess.

(c) By performing the step B in the later stage of the execution period of the step A, it is possible to set the amount of the modifying gas and the like present on the upper surface of the recess to be smaller than the amount of the modifying gas and the like present on the side and bottom surfaces of the recess. Specifically, by performing the step B in the later stage of the execution period of the step A, the inert gas is supplied after the modifying gas has filled the recess from the upper surface to the bottom surface of the recess. Since the inert gas is preferentially supplied to the upper surface of the recess, the modifying gas and the like present on the upper surface of the recess are removed (desorbed) by the inert gas. In contrast, the modifying gas and the like present on the side and bottom surfaces of the recess are hardly affected by the inert gas, so the modifying gas and the like remain inside the recess. Thereby, it is possible to set the amount of the modifying gas and the like present on the upper surface of the recess to be smaller than the amount of the modifying gas and the like present on the side and bottom surfaces of the recess.

(d) Since the execution time of the step B is shorter than the execution time of the step A, it is possible to improve a controllability of the amount of the modifying gas and the like adsorbed to the film 200a (or remaining on the film 200a). Specifically, by setting the execution time of the step B to be relatively short, the inert gas can be supplied instantaneously for only a short time. As a result, it is possible to reduce the amount of the modifying gas and the like present on the upper surface of the recess without substantially reducing the amount of the modifying gas and the like present on the side and bottom surfaces of the recess.

(e) Since the supply amount of the inert gas in the step B is smaller than the supply amount of the modifying gas in the step A, it is possible to improve the controllability of the amount of the modifying gas and the like adsorbed to the film 200a.

### (4) Modified Examples

The process sequence in the present embodiments can be modified as shown in modified examples described below. The modified examples may be combined appropriately. Unless otherwise specified, process procedures and process conditions in each step of each modified example may be substantially the same as the process procedures and the process conditions in each step of the process sequence described above.

### <First Modified Example>

The step B may be performed in the middle stage (that is, in the midway) of the execution period of the step A. According to the present modified example, it is possible to obtain substantially the same effects as in the embodiments mentioned above.

### <Second Modified Example>

The steps A to D may be performed in the order of the step B, the step A, the step C and the step D. In addition, while the inert gas is continuously supplied in the step B, the step A may be started to supply the modifying gas. Specifically, the step A may be performed in the later stage of the execution period of the step B.

According to the present modified example, it is possible to obtain at least a part of the effects of the embodiments mentioned above. In addition, according to the present modified example, by performing the step A in the later stage of the execution period of the step B, it is possible to set the amount of the modifying gas and the like present on the upper surface of the recess to be greater than the amount of the modifying gas and the like present on the side and bottom surfaces of the recess. Since the step A is performed in the later stage of the execution period of the step B, the modifying gas is supplied after the inside of the recess is filled with the inert gas. By filling the inside of the recess with the inert gas and supplying the modifying gas preferentially to the upper surface of the recess, most of the modifying gas supplied in such a manner is adsorbed on the upper surface of the recess. Therefore, the amount of the modifying gas and the like present on the upper surface of the recess may be set to be greater than the amount of the modifying gas and the like present on the side and bottom surfaces of the recess. As a result, it is possible to selectively etch the film 200a formed on the upper surface of the recess. The present modified example is particularly useful when it is desired to widen the opening of the recess.

### <Third Modified Example>

The steps A to D may be performed in the order of the step B, the step A, the step C and the step D. In addition, while the inert gas is continuously supplied in the step B, the step A may be started to supply the modifying gas. Specifically, the step A may be performed in the middle stage (that is, in the midway) of the execution period of the step B.

According to the present modified example, it is also possible to obtain at least a part of the effects of the embodiments mentioned above. In addition, according to the present modified example, by performing the step A in the middle stage of the execution period of the step B, it is possible to set the amount of the modifying gas and the like present on the upper surface of the recess to be greater than the amount of the modifying gas and the like present on the side and bottom surfaces of the recess. Since the step A is performed in the middle stage of the execution period of the step B, the modifying gas is supplied after the inside of the recess is filled with the inert gas to some extent. By filling the inside of the recess with the inert gas to some extent and supplying the modifying gas preferentially to the upper surface of the recess, most of the modifying gas supplied in such a manner is adsorbed on the upper surface of the recess. Therefore, the amount of the modifying gas and the like present on the upper surface of the recess may be set to be greater than the amount of the modifying gas and the like present on the side and bottom surfaces of the recess. As a result, it is possible to selectively etch the film 200a formed on the upper surface of the recess. The present modified example is particularly useful when it is desired to widen the opening of the recess.

### <Fourth Modified Example>

As shown in the following process sequence, a step E of supplying the inert gas to the film 200a during an execution period of the step C may be further included. Specifically, the step E may be started to supply the inert gas while the etching gas is continuously supplied in the step C. The step E may be performed in the later stage of the execution period of the step C or in the middle stage (that is, in the midway) of the execution period of the step C. According to the present modified example, it is preferable that an execution period of the step E is set to be shorter than the execution period of the step C. In addition, it is preferable that the amount of the inert gas supplied in the step E is set to be smaller than the amount of the etching gas supplied in the step C.

$& lt ; Modifying gas + Inert gas \to Etching gas + Inert gas \to Temperature Increase ) \times n$

According to the present modified example, it is possible to obtain substantially the same effects as in the embodiments mentioned above. According to the present modified example, by further performing the step E, it is possible to enhance the flow of the etching gas present on the film 200a, and as a result, it is also possible to improve a controllability of the amount of the etching gas remaining on the film 200a. By performing the step E in the later stage or in the middle stage of the execution period of the step C, it is possible to improve the controllability of the amount of the etching gas and the like present on the upper surface of the recess, in particular. By setting the execution time of the step E to be shorter than the execution time of the step C and by setting the amount of the inert gas supplied in the step E to be smaller than the amount of the etching gas supplied in the step C, it is possible to improve the controllability of the amount of the etching gas and the like present on the upper surface of the recess, in particular.

### <Other Embodiments of Present Disclosure>

The technique of the present disclosure is described in detail by way of the embodiments mentioned above. However, the technique of the present disclosure is not limited thereto. The technique of the present disclosure may be modified in various ways without departing from the scope thereof.

For example, the embodiments mentioned above are described by way of an example in which the film 200a to be etched is formed on the surface of the wafer 200. However, the technique of the present disclosure is not limited thereto. For example, the film 200a to be etched may be formed on the reaction tube 203 or the like. Even in such an embodiment, it is possible to obtain substantially the same effects as in the embodiments mentioned above.

For example, the embodiments mentioned above are described by way of an example in which the wafer 200 with the recess formed on the surface thereof is used. However, the technique of the present disclosure is not limited thereto. For example, the wafer 200 with no recess formed on the surface thereof may be used. Even in such an embodiment, it is possible to obtain substantially the same effects as in the embodiments mentioned above.

Although not specifically described in the embodiments mentioned above, the inert gas may be supplied in a pulsed manner in the step B or the step E. Even in such an embodiment, it is possible to obtain substantially the same effects as in the embodiments mentioned above. According to such an embodiment, it is possible to further improve the controllability of the amount of the modifying gas remaining on the film 200a and the controllability of the amount of the etching gas remaining on the film 200a.

For example, the embodiments mentioned above are described by way of an example in which the SiO film is formed on the surface of the recess. However, the technique of the present disclosure is not limited thereto. For example, a silicon nitride film (SiN film) may be formed. In addition, a film containing a metal element may be formed. The film containing the metal element may include at least one among a film containing a single metal element alone and a film containing a metal element and further containing at least one among oxygen, nitrogen and carbon. Even in such an embodiment, it is possible to obtain substantially the same effects as in the embodiments mentioned above.

It is preferable that recipes used in each process are prepared individually in accordance with contents of each process and stored in the memory 121c via an electric communication line or the external memory 123. When starting each process, it is preferable that the CPU 121a selects an appropriate recipe among the recipes stored in the memory 121c in accordance with the contents of each process. Thus, various films of different composition ratios, qualities and thicknesses can be formed in a reliably reproducible manner by using the processing apparatus. In addition, since a burden on an operating personnel can be reduced, various processes can be started quickly while avoiding an error in operating the processing apparatus.

The recipe described above is not limited to creating a new recipe. For example, the recipe may be prepared by changing an existing recipe installed in the processing apparatus in advance. When changing the existing recipe to a new recipe, the new recipe may be installed in the processing apparatus via the electric communication line or a recording medium in which the new recipe is stored. Further, the existing recipe already stored in the processing apparatus may be directly changed to the new recipe by operating the input/output device 122 of the processing apparatus.

For example, the embodiments mentioned above are described by way of an example in which a batch type processing apparatus capable of simultaneously processing a plurality of substrates is used to etch the film. However, the technique of the present disclosure is not limited thereto. For example, the technique of the present disclosure may be preferably applied when a single wafer type processing apparatus capable of processing one or several substrates at once is used to etch the film. For example, the embodiments mentioned above are described by way of an example in which a processing apparatus including a hot wall type process furnace is used to etch the film. However, the technique of the present disclosure is not limited thereto. For example, the technique of the present disclosure may be preferably applied when a processing apparatus including a cold wall type process furnace is used to etch the film.

For example, the embodiments mentioned above are described by way of an example in which the process sequence mentioned above is performed in the same process chamber of the same processing apparatus (in-situ). However, the technique of the present disclosure is not limited thereto. For example, one step and another step of the process sequence mentioned above may be performed in different process chambers of different processing apparatuses (ex-situ), or may be performed in different process chambers of the same processing apparatus.

The process procedures and the process conditions of each process using the processing apparatuses mentioned above may be substantially the same as those of the embodiments or the modified examples mentioned above. Even in such a case, it is possible to obtain substantially the same effects as in the embodiments or the modified examples mentioned above.

Further, the embodiments and the modified examples mentioned above may be appropriately combined. The process procedures and the process conditions of each combination thereof may be substantially the same as those of the embodiments mentioned above.

### [Description of Reference Numerals]

- 200a: Film

## Claims

1. A processing method comprising
etching a film by performing a cycle a predetermined number of times,
wherein the cycle comprises:
(a) supplying a modifying gas to the film;
(b) supplying an inert gas to the film; and
(c) supplying an etching gas to the film,
wherein an execution period of (a) and an execution period of (b) are at least partially overlapped with each other in the cycle.

2. The processing method of claim 1, wherein an execution time of (b) is set to be shorter than an execution time of (a).

3. The processing method of claim 1, wherein the inert gas is supplied in a pulsed manner in (b).

4. The processing method of claim 1, wherein (b) is performed in a later stage of the execution period of (a).

5. The processing method of claim 1, wherein (b) is performed in a middle stage of the execution period of (a).

6. The processing method of claim 1, wherein a supply amount of the inert gas in (b) is set to be smaller than a supply amount of the modifying gas in (a).

7. The processing method of claim 1, wherein (a) is performed in a later stage of the execution period of (b).

8. The processing method of claim 1, wherein (a) is performed in a middle stage of the execution period of (b).

9. The processing method of claim 1, further comprising
(e) supplying the inert gas to the film during an execution period of (c).

10. The processing method of claim 9, wherein an execution time of (e) is set to be shorter than an execution time of (c).

11. The processing method of claim 9, wherein the inert gas is supplied in a pulsed manner in (e).

12. The processing method of claim 9, wherein (e) is performed in a later stage of the execution period of (c).

13. The processing method of claim 9, wherein (e) is performed in a middle stage of the execution period of (c).

14. The processing method of claim 13, wherein a supply amount of the inert gas in (e) is set to be smaller than a supply amount of the etching gas in (c).

15. The processing method of claim 1, wherein a recess is provided on a surface of a substrate with the film formed thereon.

16. The processing method of claim 15, wherein the modifying gas and the inert gas are supplied from a direction different from a bottom direction of the recess.

17. The processing method of claim 15, wherein a pressure of a space in which the substrate is present is set to be higher during (a) than during (c).

18. A method of manufacturing a semiconductor device, comprising
etching a film by performing a cycle a predetermined number of times,
wherein the cycle comprises:
(a) supplying a modifying gas to the film;
(b) supplying an inert gas to the film; and
(c) supplying an etching gas to the film,
wherein an execution period of (a) and an execution period of (b) are at least partially overlapped with each other in the cycle.

19. A program that causes, by a computer, a processing apparatus to perform:
etching a film by performing a cycle a predetermined number of times,
wherein the cycle comprises:
(a) supplying a modifying gas to the film;
(b) supplying an inert gas to the film; and
(c) supplying an etching gas to the film,
wherein an execution period of (a) and an execution period of (b) are at least partially overlapped with each other in the cycle.

20. A processing apparatus comprising:
a first gas supplier configured to supply a modifying gas to a film;
a second gas supplier configured to supply an inert gas to the film;
a third gas supplier configured to supply an etching gas to the film; and
a controller configured to be capable of controlling the first gas supplier, the second gas supplier and the third gas supplier to perform: etching the film by performing a cycle a predetermined number of times,
wherein the cycle comprises:
(a) supplying the modifying gas to the film;
(b) supplying the inert gas to the film; and
(c) supplying the etching gas to the film,
wherein an execution period of (a) and an execution period of (b) are at least partially overlapped with each other in the cycle.
